Europäisches Patentamt

European Patent Office

Office européen des brevets

(11) Veröffentlichungsnummer: **0 307 585**
**A2**

(12) **EUROPÄISCHE PATENTANMELDUNG**

(21) Anmeldenummer: 88111820.2

(22) Anmeldetag: 22.07.88

(51) Int. Cl.⁴: **C03C 17/10**

(30) Priorität: 14.09.87 DE 3731167

(43) Veröffentlichungstag der Anmeldung:
22.03.89 Patentblatt 89/12

(84) Benannte Vertragsstaaten:
BE CH DE ES FR GB IT LI LU NL SE

(71) Anmelder: **SCHERING AKTIENGESELLSCHAFT**
**Berlin und Bergkamen**
**Müllerstrasse 170/178 Postfach 65 03 11**
**D-1000 Berlin 65(DE)**

(72) Erfinder: **Herold, Roland**
**Wernigeroder Strasse 11**
**D-1000 Berlin 10(DE)**
Erfinder: **Dannenberg, Eveline**
**Raschdorffstrasse 16**
**D-1000 Berlin 65(DE)**
Erfinder: **Majentny, Klaus**
**Ludolfingerweg 54a**
**D-1000 Berlin 28(DE)**
Erfinder: **Middeke, Hermann-Josef, Dr.**
**Sächsische Strasse 12**
**D-1000 Berlin 31(DE)**

(54) **Verfahren zur haftfesten Metallisierung von Emails.**

(57) Die Erfindung betrifft ein Verfahren zur haftfesten Metallisierung von Emails, dadurch gekennzeichnet, daß die Emailoberfläche zunächst aufgerauht wird, wobei gleichzeitig mit der Aufrauhung oder darauffolgend eine Ultraschallbehandlung erfolgt, worauf die Oberfläche mittels eines Netzmittels konditioniert, anschließend aktiviert und dann chemisch metallisiert wird.

EP 0 307 585 A2

## VERFAHREN ZUR HAFTFESTEN METALLISIERUNG VON EMAILS

Die Erfindung betrifft ein Verfahren zur haftfesten Metallisierung von Emails.

Es ist bereits bekannt, Emails mit einer haftfesten Metallschicht zu versehen, was durch den Einbrand von Dickschichtpasten erfolgt (DE-OS 35 35 972). Nachteilig sind hierbei die hohe Temperatur zum Einbrand der Metallisierung sowie die aufwendige Herstellung geeigneter Metallpasten.

Für metallische Verbindungen mehrerer Ebenen eines Schaltungsaufbaus sind diese Pasten kaum geeignet. Sie zeigen im allgemeinen eine niedrige elektrische Leitfähigkeit, die Schichtdicke (Leiterhöhe) ist auf maximal 10 $\mu$m begrenzt.

Aufgabe der vorliegenden Erfindung ist die Schaffung eines Verfahrens, welches eine technisch einfache haftfeste Metallisierung von Emails ermöglicht.

Diese Aufgabe wird durch ein Verfahren gemäß dem kennzeichnenden Teil des Patentanspruches gelöst.

Vorteilhafte Ausführungsformen dieses Verfahrens sind in den Unteransprüchen beschrieben.

Das erfindungsgemäße Verfahren gestattet es, beliebig geformte Werkstücke aus Email, das heißt auch Löcher und Röhren, haftfest zu metallisieren, was technisch von außerordentlicher Bedeutung ist. Da außerdem durch einen anschließenden galvanischen Prozeß beliebige Metalle oder Metallschichten in jeweils gewünschter Qualität und Dikke aufgebracht werden können, ist es bisher erstmalig möglich, beliebige Metallstrukturen auf der Emailoberfläche zu erzeugen.

Als Emails können Spezialgläser verwendet werden, die chemisch als Salze von Polykieselsäuren anzusehen sind und durch Einbrennen bei einer Temperatur über 425˙ C mit einem Metall, wie Stahl oder Kupfer, verbunden sind. Die geschlossene Struktur dieser Salze ist zum Teil durch Alkali- und/oder Erdalkalioxide geöffnet. Ebenso können auch Oxide höherwertiger Elemente wie Aluminium, Blei, Bor, Cobalt, Nickel, Titan, Zink und/oder Zirkonium in das Kieselsäurenetzwerk eingebaut sein oder auch anorganische Zusätze wie Sulfide, Fluoride und/oder Arsenide. Die Emails können in glasartiger oder teilkristalliner Struktur vorliegen.

Die Aufrauhung der Emailoberfläche soll mechanisch und/oder chemisch erfolgen. Eine mechanisch chemische Aufrauhung kann vorteilhafterweise so durchgeführt werden, daß die Emailoberfläche zunächst durch Sandstrahlen vergrößert wird und dann mit einer Ätzlösung, zum Beispiel einer Ammoniumhydrogenfluorid-Lösung, entlang mechanischer Spannungen oder Mikrorisse schmale Gräben ins Email geätzt werden. In der Regel kann die erforderliche Mikrorauhigkeit allein durch einen Ätzschritt erreicht werden, wofür insbesondere eine Ammoniumhydrogenfluoridlösung geeignet ist, der gegebenenfalls noch eine Behandlung in einem Säuregemisch angeschlossen werden kann.

An die Aufrauhung schließt sich eine Ultraschallbehandlung an, die dazu dient, loses Material von der Emailoberfläche zu entfernen. Für eine ausreichende Haftfestigkeit des nachfolgend abzuscheidenden Metalls auf der Oberfläche ist dieser Schritt unbedingt notwendig. Ultraschallenergie wird entweder schon während des Ätzschrittes oder danach, zum Beispiel in einem Spülschritt auf das Werkstück gegeben, indem es in ein Bad getaucht wird, das einen Ultraschallschwinger enthält. Eine kurze Verweilzeit von beispielsweise fünf Minuten ist in den meisten Fällen ausreichend. Die Ultraschallbehandlung wird bei Raumtemperatur oder schwach erhöhter Temperatur durchgeführt.

Die aufgerauhte Email wird nun für die nachfolgende Aktivierung mit einem Netzmittel konditioniert. Hierfür eignen sich anionische, kationische als auch nichtionogene Netzmittel in etwa 1%iger Lösung. Der pH-Wert der Lösung ist unkritisch. Gute Ergebnisse lassen sich mit Konditionierungslösungen erzielen, die 2%ig an Schwefelsäure sind. Optimal für die Dauer der Konditionierung ist eine Zeit von fünf Minuten. Die Konditionierung erfolgt bei Raumtemperatur oder leicht erhöhter Temperatur.

An diese Konditionierung schließt sich die Aktivierung der Oberfläche vorzugsweise mit Palladiumkeimen an. Dazu wird eine wäßrige Lösung eines Palladiumkomplexes verwendet, deren pH-Wert vorzugsweise bei 10,5 liegt, so daß die Emailoberfläche durch den Aktivator nicht angegriffen wird. Die Aktivierung erfolgt bei schwach erhöhter Temperatur (etwa 40˙ C), die bevorzugte Dauer liegt auch hier bei etwa fünf Minuten. Nach der Reduktion der Palladiumionen zum Metallkeim kann die Emailoberfläche in einem reduktiv außenstromlosen Bad chemisch metallisiert werden.

Die erfindungsgemäß metallisierten Emailteile finden Verwendung in der Elektrotechnik und Elektronik.

Die folgenden Beispiele dienen der Erläuterung der Erfindung.

Beispiel 1:

Ein mit einer glasartigen, kobalthaltigen Email überzogener Stahlkern wurde mit Korundpartikeln vom Durchmesser 50 $\mu$m gestrahlt, bis die Emailoberfläche gleichmäßig mattiert war. Das so behandelte Werkstück wurde anschließend fünf Minuten bei Raumtemperatur unter Ultraschalleinwirkung in einer 5%migen Lösung aus Ammoniumhydrogenfluorid angeätzt, durch Spülen unter Ultraschall von anhaftemdem Fluorid befreit und bei 150°C getrocknet. Danach wurde das Teil in einem sauren Conditionierer bei 40°C innerhalb fünf Minuten für die Aktivierung vorbereitet, nach dem Zwischenspülen durch 5-minütiges Tauchen in Aktivatorlösung aktiviert, gespült, das Pd$^{2+}$ auf der Oberfläche in fünf Minuten mit einem geeigneten Reduktor zum Metall reduziert und nachfolgend chemisch reduktiv mit einer Schicht von 3 μm Kupfer belegt. Die Metallschicht wies zum Email eine Haftfestigkeit von 0,75 N/mm (im peel-Test) auf.

Beispiel 2:

Eine gelochte Kupferplatte, die mit einem alkaliarmen Email überzogen worden war, wurde mit einem alkalischen Tensid entfettet, und bei Raumtemperatur fünf Minuten unter Ultraschall in eine 2%ige Lösung von Ammoniumhydrogenfluorid getaucht und anschliessend unter Ultraschalleinwirkung gespült. Wie in Beispiel 1 beschrieben, wurde die Oberfläche anschließend konditioniert, aktiviert und metallisiert. Es wurde eine Haftfestigkeit zwischen Email und Verkupferung von 1,2 N/mm im peel-Test gemessen.

Beispiel 3:

Eine gelochte Stahlplatte wurde elektrophoretisch mit einer rekristallierten Glaskeramik überzogen. Die Platte wurde zunächst mit einer 1%igen Ammoniumhydrogenfluoridlösung in zehn Minuten bei 40°C aufgerauht, dann unter Ultraschall in 10%iger Natronlauge nachbehandelt. Die Email wurde dann wie beschrieben konditioniert, aktiviert und metallisiert. Nach der Metallisierung wurde eine Haftfestigkeit Kupfer/Email von 0,6 N/mm gemes-sen.

Beispiel 4:

Eine in gleicher Weise wie in Beispiel 3 isolierte Metallplatte wurde zunächst fünf Minuten mit einem Gemisch aus Fluorborsäure und Methansulfonsäure (20 %) bei Raumtemperatur unter Ultraschall behandelt und dann gespült. Nach der Konditionierung, Aktivierung und Metallisierung wurde eine Haftfestigkeit von 1,4 N/mm ermittelt.

Beispiel 5:

Eine gelochte Stahlplatte wurde mit einer rekristallisierenden, alkaliarmen Email beschichtet, anschließend durch Tauchen in eine alkalische Lösung eines Detergenzes entfettet und unter Ultraschalleinwirkung in einer 2%igen Ammoniumhydrogenfluoridlösung aufgeschlossen. Nach dem Spülen, Conditionieren und Aktivieren der Oberfläche wurde chemisch reduktiv eine 3μm-dicke Kupferschicht auf der Oberfläche abgeschieden. Auf diese Kupferoberfläche wurde ein Photoresist laminiert und durch eine Vorlage belichtet. Nach dem Entwickeln des Resists wurde die freiliegende Metalloberfläche galvanisch mit Kupfer verstärkt und mit einer Endschicht aus Nickel und Gold galvanisch versehen. Nach dem Strippen des Resist und dem Entfernen der Basismetallisierung wurde die so entstandene Leiterplatte mit konventionellen bedrahteten Bauelementen bestückt.

**Ansprüche**

1. Verfahren zur haftfesten Metallisierung von Emails, dadurch gekennzeichnet, daß die Emailoberfläche zunächst aufgerauht wird, wobei gleichzeitig mit der Aufrauhung oder darauffolgend eine Ultraschallbehandlung erfolgt, worauf die Oberfläche mittels eines Netzmittels konditioniert, anschließend aktiviert und dann chemisch metallisiert wird.

2. Verfahren gemäß Anspruch 1, dadurch gekennzeichnet, daß die Aufrauhung mechanisch und/oder chemisch erfolgt.

3. Verfahren gemäß Anspruch 2, dadurch gekennzeichnet, daß die chemische Aufrauhung durch Einwirkung von Säuren, Basen oder Salzen erfolgt.

4. Verfahren gemäß Anspruch 3, dadurch gekennzeicht, daß als Säuren Mineralsäuren, insbesondere Halogenwasserstoffsäuren, oder organische Säuren, als Basen Alkalihydroxide, insbesondere Natriumhydroxid, oder Ammoniumhydroxid und als Salze Phosphate oder Fluoride, insbesondere Ammoniumhydrogenfluorid, verwendet werden.

5. Verfahren gemäß Anspruch 1, dadurch gekennzeichnet, daß die Ultraschallbehandlung mittels eines Ultraschallschwingers durchgeführt wird.

6. Verfahren gemäß Anspruch 5, dadurch gekennzeichnet, daß die Ultraschallbehandlung in einer Lösung durchgeführt wird.

7. Verfahren gemäß Anspruch 6, dadurch gekennzeichnet, daß es sich um eine wässrige Lösung handelt.

8. Verfahren gemäß Anspruch 1, dadurch gekennzeichnet, daß ein anionisches, kationisches oder nichtionisches Netzmittel verwendet wird.

9. Verfahren gemäß Anspruch 8, dadurch gekennzeichnet, daß das Netzmittel in schwefelsaurer Lösung angewendet wird.

10. Verfahren gemäß Anspruch 1, dadurch gekennzeichnet, daß die Aktivierung mittels eines Palladiumkomplexes erfolgt.

11. Metallisierte Emails hergestellt nach Verfahren gemäß Ansprüchen 1 bis 10.